# EUROPÄISCHE PATENTANMELDUNG

(11) **EP 1 498 208 A1**
(43) Veröffentlichungstag der Anmeldung: **19.01.2005**
(21) Anmeldenummer: 04011037.1
(22) Anmeldetag: 10.05.2004
(51) Int. Cl.: B23K 1/00

(54) **Anordnung zur Befestigung eines Bauelements**

(30) Priorität: 18.07.2003 DE 10332695
(71) Anmelder: Robert Bosch GmbH, 70442 Stuttgart (DE)
(72) Erfinder: Hornung, Stefan, 70771 Leinfelden-Echterdingen (DE); Koester, Thomas, 72762 Reutlingen (DE); Urbach, Peter, 72762 Reutlingen (DE)

(57) **Zusammenfassung**

Die vorliegende Erfindung schafft eine Anordnung 1 zur Befestigung eines Bauelements 2, insbesondere eines elektronischen Leistungsbauelements 2, an mindestens einem Träger 3, 7, wobei ein Lotmittel 5 auf einer Lotstelle 4 auf der dem jeweiligen Träger 3, 7 zugewandten Oberfläche des Bauelements 2 vorgesehen ist, wobei mindestens eine Ausnehmung 9 in der der Lotstelle 4 zugewandten Oberfläche des jeweiligen Trägers 3, 7 für eine Aufnahme eines Lotmittelüberschusses oder für eine Lotbegrenzung vorgesehen ist.

## Beschreibung

### STAND DER TECHNIK

Die vorliegende Erfindung betrifft eine Anordnung zur Befestigung eines Bauelements, insbesondere eines elektronischen Bauelements, an mindestens einem Träger, wobei ein Lotmittel auf einer Lotstelle auf der dem jeweiligen Träger zugewandten Oberfläche des Bauelements vorgesehen ist.

Im Kraftfahrzeugbereich finden aufgrund der weiter fortschreitenden Miniaturisierung insbesondere Bauelemente, beispielsweise elektronische Leistungsbauelemente, mit einer hohen Stromtragfähigkeit Verwendung. Insbesondere Halbleiter-Bauelemente, welche sehr hohe Ströme tragen und schalten können, werden häufig eingesetzt. Ein gängiges Problem dieser Leistungsbauelemente stellt die hohe Verlustleistung dar, welche zur Vermeidung von Bauteilschäden durch einen geeigneten Aufbau von beispielsweise einem Chip an die Umgebung abgeführt werden muss.

Dies wird im Chip-Bereich beispielsweise dadurch gelöst, dass eine Wärmeleitfolie mit einer Chip-Seite und einer geeigneten Kühlfläche verbunden wird.

Nachteilig daran ist allerdings, dass die schlechte Wärmeleitfähigkeit der Folie die thermische und elektrische Leistungsfähigkeit des Chips einschränkt.

Im Stand der Technik findet sich der Ansatz, dass für eine Gewährleistung einer hinreichend hohen Stromtragfähigkeit die Chip-Oberseite mit Dickdraht-Bonds kontaktiert wird.

Nachteilig bei diesem Ansatz ist der hohe Flächenbedarf der Bond-Füße und die begrenzte Stromtragfähigkeit. Somit ist dieser Ansatz nicht für Hochstrom-Applikationen verwendbar. Zudem weist die Bondtechnik ein schlechtes Schaltverhalten durch Streuinduktivitäten und fehlende Prüfkonzepte paralleler Bond-Schleifen auf.

Aufgrund der oben genannten Nachteile gewinnen zunehmend sogenannte Aufbau- und Verbindungstechniken an Bedeutung, bei denen eine beidseitige Lötung der Leistungsbauelemente zwischen geeignete Träger, insbesondere Substrate und Verdrahtungsträger, und eine direkte großflächige Kontaktierung an bestimmte Wärmesenken stattfindet. Dadurch kann sowohl die elektrische als auch die thermische und thermomechanische Leistung verbessert werden.

Gemäß dem Stand der Technik werden beispielsweise Halbleiter-Chips auf sogenannte Leadframes bzw. Stanzgitter, beispielsweise aus Kupfer, gelötet. Es finden im Stand der Technik auch andere Materialien, wie beispielsweise sogenannte DBC-Keramiken (Direct-Bonded-Copper-Materials) Verwendung, welche eine bessere Wärmeausdehnung als Kupfer aufweisen und somit eine streßärmere Verbindung mit dem Halbleiter-Chip aufweisen.

Eine derartige Verlötung des Halbleiter-Chips zwischen geeigneten Substraten wird gemäß dem Stand der Technik mittels sogenannter Lot-Bumps (d.h. Lotkugeln, die auf der Halbleiter-Chip-Oberfläche aufgetragen werden) durchgeführt. Die Substrate enthalten ferner die entsprechenden Leiterbahnen für die zu realisierende Schaltung. Diese Technik findet beispielsweise bei einer Verlötung eines MOS-Transistors zwischen zwei Verdrahtungsträgern Anwendung. Beide Substrate übernehmen Funktionen der mechanischen Stabilisierung, der Wärmeableitung und der elektrischen Verdrahtung.

Allerdings besteht eine Schwierigkeit bei der Montage und dem Verlöten von Bauelementen, wie beispielsweise Leistungstransistoren, Widerständen, Shunts oder Kondensatoren in einer Stapelanordnung zwischen beispielsweise zwei Verdrahtungsträgern bzw. zwei Substraten darin, dass Toleranzen sowohl in lateraler wie auch in vertikaler Richtung beim Lötvorgang auftreten. Diese werden hervorgerufen durch die verschiedenen Beiträge der geometrischen Toleranzen der einzelnen Bauteile, wie beispielsweise Dickenschwankungen, Verbiegungen, Unebenheiten oder dergleichen oder Toleranzen beim Prozessvorgang, wie beispielsweise Positionierungsgenauigkeit bei der Montage, keilige Lötungen oder verrutschende Bauteile beim Lötvorgang. Insbesondere entlang der vertikalen Achse können die Abstände zwischen dem Boden- und dem Deckelsubstrat erhebliche Unterschiede aufweisen. Diese Schwankungen werden dadurch gelöst, dass bestimmte Lötstellen, sogenannte Lotdepots, mit einer ausreichenden Menge eines Lotmittels zur Verfügung gestellt werden.

Nachteilig daran ist jedoch, dass aufgrund der Zurverfügungstellung eines ausreichenden Lotdepots bei einer ungünstigen Addition der Toleranzen ein starker Lotüberschuss auftreten kann. Dieser Lotüberschuss kann unter Umständen sogenannte Lotnasen erzeugen, welche an den offenliegenden Metallstrukturen, beispielsweise der Chip-Kante, Kurzschlüsse erzeugen können. Dies hat hohe Ausbeuteverluste aufgrund unzureichender Fertigungssicherheiten zur Folge, wobei sich dieses Problem mit zunehmender Substratfläche aufgrund der schwer zu kontrollierenden Ebenheiten bzw. Toleranzen verstärkt.

### VORTEILE DER ERFINDUNG

Die erfindungsgemäße Anordnung zur Befestigung eines Bauelements mit den Merkmalen des Anspruchs 1 weist gegenüber dem bekannten Lösungsansatz den Vorteil auf, dass ein überschüssiges Lotmittel durch mindestens eine Ausnehmung aufgenommen, das Auslaufen des Lotmittels auf den Substraten verhindert und ein Verschwimmen bzw. Verrutschen der Bauteile verhindert wird. Somit kann ohne Bedenken ein ausreichendes Lotdepot für eine hohe Kontaktierungssicherheit vorgesehen werden, ohne dass die Gefahr einer Bildung sogenannter Lotnasen durch herausgedrücktes überschüssiges Lotmittel auftreten kann, wodurch die Fertigungssicherheit und die Bauteilausbeute erheblich verbessert werden können.

Weitere Ausgestaltungen der Erfindung ergeben sich aus den Unteransprüchen.

Ein wesentlicher Gedanke der Erfindung besteht darin, dass mehrere Ausnehmungen symmetrisch zueinander im Bereich einer Lotgegenstelle auf der dem Lotmittel zugewandten Oberfläche des jeweiligen Trägers angeordnet sind. Dadurch wird eine gleichmäßige Aufnahme des Lotmittels erreicht und ein "Verschwimmen" bzw. eine Verschiebung der Bauteile vermieden.

Eine weitere Ausgestaltung der vorliegenden Erfindung besteht darin, dass die Ausnehmungen im Bereich der äußeren Begrenzungslinie der Lotgegenstelle auf dem jeweiligen Träger angeordnet sind. Somit wird eine Anordnung der Ausnehmungen in einem eventuellen Tabu- bzw. Risikobereich der Anordnung vermieden.

Gemäß einer weiteren bevorzugten Ausgestaltung weisen die Ausnehmungen vorzugsweise eine halbschalenförmige, wannenähnliche, dimpelähnliche, pyramidenähnliche oder kastenähnliche Form auf. Jedoch sind andere Formen ebenfalls denkbar.

Vorteilhaft beträgt die Tiefe der Ausnehmungen jeweils maximal drei Viertel der entsprechenden Trägerebene. Somit wird ein Durchbruch der Trägerebene und ein Auslaufen des Lotmittels vermieden.

Vorzugsweise sind die Ausnehmungen jeweils als halbschalenförmige Löcher mit einer Breite von ca. 0,6 mm und einer Tiefe von ca. 0,2 bis 0,25 mm ausgebildet. Bei einer gängigen Dicke der Lotverbindung kann somit vorzugsweise in etwa bis zu 50 % bis 70 % des gesamten auf der Lotstelle aufgebrachten Lotmittels in den Ausnehmungen aufgenommen werden. Dies bietet eine hinlänglich ausreichende Aufnahmemöglichkeit des Lotmittels.

Gemäß einer weiteren bevorzugten Ausgestaltung sind die Ausnehmungen in der Verdrahtungsebene eines Schaltungsträgers, beispielsweise eines Leistungssubstrates, vorgesehen.

Vorzugsweise dienen die Ausnehmungen zusätzlich oder insbesondere als Lötbegrenzungen. Dadurch werden bestimmte Tabubereiche durch eine eventuelle unerwünschte Belötung abgeschirmt.

Gemäß eines bevorzugten Ausführungsbeispiels sind die Ausnehmungen jeweils mittels eines nasschemischen Ätzverfahrens, Sputtern, eines physikalisch-chemischen Ätzverfahrens, eines formgebundenen Fertigungsverfahrens, Fräsen oder eines ähnlichen Verfahrens gebildet. Da beispielsweise die Substrate des Halbleiter-Chips für den Herstellungsprozess ohnehin ein nasschemisches Ätzverfahren durchlaufen, können während diesem nasschemischen Ätzverfahren gleichzeitig die Ausnehmungen gebildet werden. Somit ist kein zusätzlicher Verfahrensschritt notwendig.

### ZEICHNUNGEN

Ausführungsbeispiele der Erfindung sind in den Zeichnungen dargestellt und in der nachfolgenden Beschreibung näher erläutert.

In den Zeichnungen zeigen:
- Figur 1: eine perspektivische Darstellung eines Stapelaufbaus, bei welchem zwei MOS-Transistoren beidseitig zwischen zwei Trägern gelötet werden;
- Figur 2a - 2d: schematische Darstellungen verschiedener Ausnehmungsquerschnitte gemäß bevorzugter Ausführungsbeispiele der vorliegenden Erfindung;
- Figur 3a - 3c: schematische Draufsichten auf die der jeweiligen Lotstelle zugewandten Oberflächen der jeweiligen Träger, welche Anordnungen der Ausnehmungen gemäß verschiedenen Ausführungsbeispielen der vorliegenden Erfindung darstellen;
- Figur 4a: eine schematische Querschnittsdarstellung einer erfindungsgemäßen Anordnung bei einem minimalen Abstand der beiden Träger;
- Figur 4b: eine schematische Querschnittsdarstellung der erfindungsgemäßen Anordnung in Figur 4a bei maximalem Abstand der beiden Träger;
- Figur 5: eine schematische Querschnittsdarstellung einer Anordnung gemäß einem weiteren Ausführungsbeispiel der vorliegenden Erfindung; und
- Figur 6: eine weitere schematische Querschnittsdarstellung eines weiteren bevorzugten Ausführungsbeispiels der vorliegenden Erfindung.

### BESCHREIBUNG DER AUSFÜHRUNGSBEISPIELE

In den Figuren bezeichnen gleiche Bezugszeichen gleiche oder funktionsgleiche Komponenten.

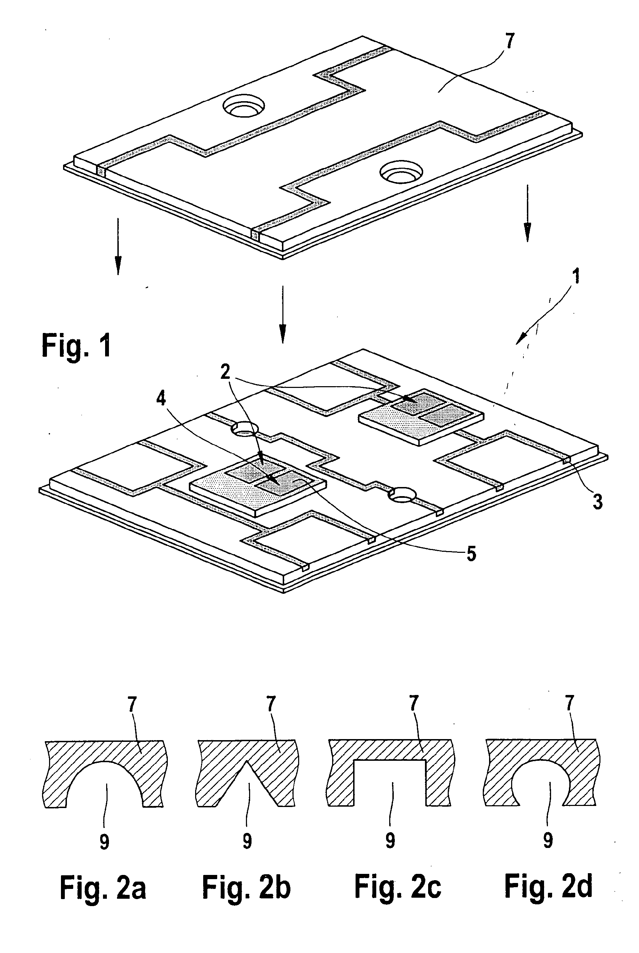

In Figur 1 ist schematisch eine beispielhafte Stapelanordnung 1, teilweise in Explosionsansicht, dargestellt. Zwei Bauelemente 2, beispielsweise zwei MOS-Transistoren 2, sind auf einem unteren Träger 3, beispielsweise einem DBC-Substrat, befestigt. Im Bereich des Bauelements 2 ist ein Lotdepot 4 bzw. eine Lotstelle 4 vorgesehen, in welchem sich ein ausgewähltes Lotmittel 5 befindet.

Ferner ist ein oberer Träger 7 vorgesehen, welcher auf dem unteren Träger 3 und dem daran angeordneten Bauelement 2 mittels dem Lotmittel 5 in dem Lotdepot 4 befestigt werden soll, wobei eine der Lotstelle 4 entsprechende Lotgegenstelle (nicht sichtbar) an der dem unteren Träger 3 zugewandten Fläche des oberen Trägers 7 angeordnet ist. Die Lotgegenstelle kommt beim Zusammenbau der Anordnung 1 auf dem Lotdepot 4 bzw. der Lotstelle 4 zur Anlage.

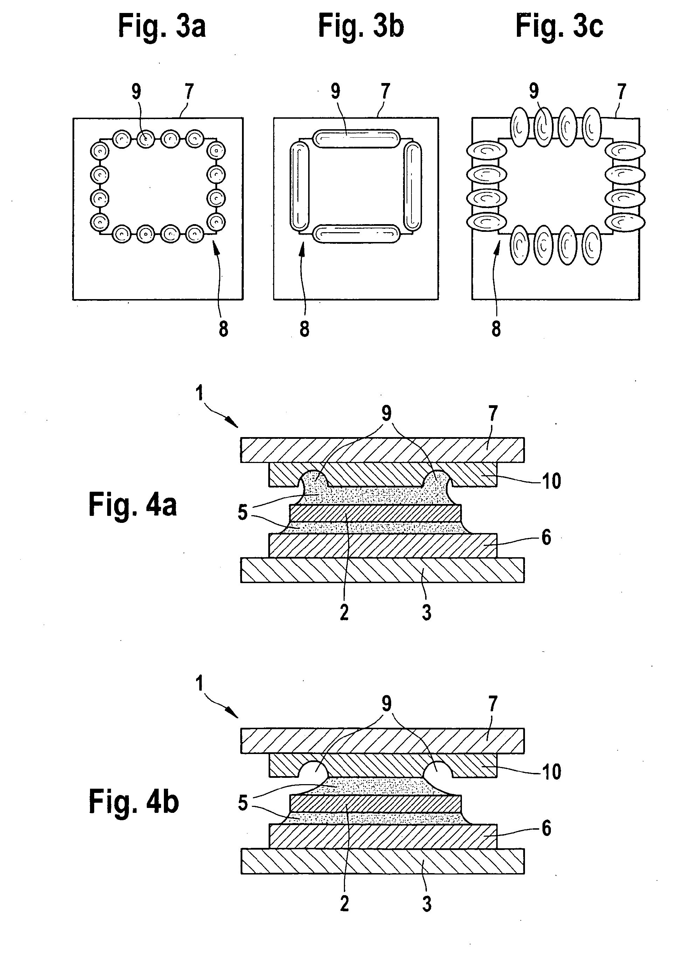

In den Figuren 2a bis 2d und den Figuren 3a bis 3c sind mehrere Ausführungsbeispiele der erfindungsgemäßen Ausnehmungen 9 schematisch dargestellt, wobei die Ausnehmungen 9 verschiedene Formen, Anordnungen; Tiefen etc. aufweisen und/oder in einer unterschiedlichen Anzahl vorgesehen sein können. An dieser Stelle sei erwähnt, dass anwendungsspezifisch eine Auswahl dahingehend getroffen werden sollte, in welcher Anzahl, in welcher Geometrie, mit welchem Abstand zueinander und in welcher Anordnung die Ausnehmungen 9 an der Unterseite des oberen Trägers 7 angeordnet werden.

Figur 2 illustriert vorteilhafte Querschnittsformen der Ausnehmungen 9, welche wie in Figur 2a dargestellt halbschalenförmig, wie in Figur 2b dargestellt pyramidenförmig, wie in Figur 2c dargestellt rechteckig oder wie in Figur 2d dargestellt dimpelförmig ausgebildet sein können. Andere Ausgestaltungen der Ausnehmungen 9 sind jedoch ebenfalls denkbar und entsprechend der jeweiligen Applikation auszuwählen.

Durch beispielsweise ein nasschemisches Ätzverfahren wird eine isotrope Ätzung gemäß Figur 2d mit leicht negativen Flanken und einer scharfen Kantendefinition erzeugt. Derartige Kanten sind besonders vorteilhaft, da sie das Auslaufen des überschüssigen Lotmittels verhindern. Erst durch ein Überangebot an Lötmittel kommt es zum Füllvorgang der Ausnehmungen 9. Überschüssiges Lotmittel wird bei Bedarf in den Ausnehmungen 9 gepuffert und ein Auslaufen über die Ausnehmungen hinaus wird durch eine derartige Form effektiv unterbunden.

Verschiedene Geometrien, wie beispielsweise Kastenprofile, werden durch alternative anisotrope Strukturierungsverfahren, wie beispielsweise Ionenstrahl-Ätzen oder formgebundene Fertigungsverfahren, realisiert. Entscheidend für die Funktionen der Ausnehmungen 9 als Lötbegrenzung sind deutlich konturierte Kanten, wie in den Figuren 2a bis 2d dargestellt.

Verschiedene vorteilhafte Ausgestaltungen der Ausnehmungen 9 bezüglich der Anzahl, dem Abstand und der Anordnung der Ausnehmungen 9 zueinander sind in den Figuren 3a bis 3c schematisch illustriert, wobei jeweils die untere Fläche des oberen Trägers 7 in Draufsicht dargestellt ist. Wie oben bereits erläutert, ist an der unteren Fläche des oberen Trägers 7 eine der jeweiligen Lotstelle 4 entsprechende Lotgegenstelle 8 vorgesehen, welche beim Zusammenbau der Anordnung 1 auf dem Lotdepot 4 bzw. der Lotstelle 4 des unteren Trägers 3 zu liegen kommt. Vorzugsweise sind mehrere Ausnehmungen 9 vorgesehen, welche entlang der äußeren Begrenzungslinie bzw. Umfangslinie der Lotgegenstelle 8 positioniert sind, wie in den Figuren 3a bis 3c ersichtlich.

Gemäß Figur 3a sind gezielt Ausnehmungen in Form von halbschalenförmigen Löchern auf der Umfangslinie der Lotgegenstelle 8 mit einem bestimmten Abstand zueinander angeordnet. Eine einzelne Ausnehmung kann die Funktion einer Aufnahme des Lotüberschusses nur eingeschränkt übernehmen, somit wird diese Wirkung durch eine gezielte Anordnung mehrerer Ausnehmungen erreicht. Auf jeder Seite der beispielsweise rechteckigen Lotgegenstelle 8 sind eine bestimmte Anzahl an Ausnehmungen 4 zur Aufnahme eines etwaigen Lotüberschusses symmetrisch zueinander vorgesehen. Somit wird ein symmetrischer Anpressdruck und eine symmetrische Aufnahme des Lotüberschusses gewährleistet und ein Verschieben der Bauteile bei der Montage vermieden.

Somit wird verhindert, dass aufgrund eines Überangebotes an Lotmittel dieses entlang einer Kante auf dem Substrat auslaufen bzw. herausgedrückt werden kann, was bei Kontakt mit beispielsweise einer Chip-Kante zu einem Kurzschluss und somit zu einem elektrischen Ausfall des Transistors bzw. des jeweiligen Bauelements 2 und somit der gesamten Anordnung 1 führen würde. Ein einseitiges Auslaufen des Lotmittels wird durch eine derartige symmetrische Anordnung der Ausnehmungen 9 verhindert. Überschüssiges Lotmittel wird in den Ausnehmungen 9 aufgefangen, wobei der Prozess aufgrund der Symmetrie weitestgehend selbstjustierend ist.

Wie in den Figuren 3b und 3c jeweils ersichtlich, können die Ausnehmungen 9 auch andere Formen, eine andere Anzahl oder eine unterschiedliche Anordnung bezüglich der Umfangslinie der Lotgegenstelle 8 aufweisen.

In Fig. 3b sind vier Ausnehmungen 9 wannenförmig, jeweils eine über nahezu die gesamte Seitenausdehnung der Lotgegenstelle 4, symmetrisch angeordnet, wobei die jeweilige Längsachse parallel zur jeweiligen Umfangslinie verläuft.

In Fig. 3c dagegen sind auf jeder Umfangsseite der Lotgegenstelle 4 jeweils vier ovalförmige Ausnehmungen vorgesehen, deren Längsachse jeweils senkrecht zur jeweiligen Umfangslinie verläuft und welche mit ihrer jeweiligen Mitte etwas nach außen hin versetzt sind.

Entscheidend ist allerdings, dass ein genügend großes Volumen durch die Gesamtheit der Ausnehmungen 9 geschaffen wird, um einen etwaigen Lotüberschuss beim Zusammenbau der Anordnung 1 aufnehmen und somit die oben genannten Nachteile vermeiden zu können. Das Volumen der Ausnehmungen 9 ergibt sich im wesentlichen aus der Tiefe und dem jeweiligen Radius der einzelnen Ausnehmungen. Die maximale Tiefe der jeweiligen Ausnehmungen 9 ist durch die Dicke des oberen Trägers 7 begrenzt. Vorzugsweise sollte die Tiefe der Ausnehmungen 9 maximal drei Viertel der Dicke des oberen Trägers 7 betragen, um die elektrische Funktion der Anordnung nicht einzuschränken.

Beispielsweise können die Ausnehmungen 9 in einem DBC-Substrat mit einer o,30 mm Kupferbelegung eine Breite von ca. 0,6 mm und eine Tiefe von ca. 0,20 mm bis 0,25 mm aufweisen. Somit wird gewährleistet werden, dass ein bestimmter Prozentsatz, beispielsweise bis zu etwa 50 % - 70 %, des gesamten auf der Lotstelle 4 aufgebrachten Lotmittels in den Ausnehmungen 9 aufgenommen wird, wobei typische Lotschichtdicken ca. 50 µm bis 100 µm betragen.

Bei entsprechender Anordnung der Ausnehmungen 9 dienen die Ausnehmungen 9 gleichzeitig oder insbesondere als Lotbegrenzungen und verhindern, dass beim Lötvorgang bestimmte Tabubereiche, wie beispielsweise die Kante des Chips, in Kontakt mit dem Lotmittel gelangt. Ein Abstand zu eventuellen Tabubereichen von wenigen Hundert µm ist je nach Anwendung ausreichend.

Derartige Ausnehmungen 9 können beispielsweise mittels eines kostengünstigen nasschemischen Ätzverfahrens, vorzugsweise in Metallen wie Kupfer, geätzt werden. Dabei können entsprechend der gewünschten Form der Ausnehmungen 9 entsprechende Maskierungen gewählt werden. Der bei der Herstellung von Substraten eingesetzte Ätzprozess zur Strukturierung der Kupfer-Verdrahtungsebene kann gleichzeitig zur Herstellung der Ausnehmungen 9 verwendet werden. Somit kann ein zusätzlicher Herstellungsschritt und zusätzliche Kosten eingespart werden. Jedoch können auch andere Herstellungsverfahren, wie beispielsweise Sputtern, physikalisch-chemische Ätzverfahren, formgebundene Fertigungsverfahren, Fräsen oder ähnliche Verfahren verwendet werden.

Die Figuren 4a und 4b illustrieren eine Seitenansicht einer Anordnung gemäß einem Ausführungsbeispiel der vorliegenden Erfindung, jeweils im Schnitt, wobei Figur 4a den minimalen Abstand der beiden Träger 3 und 7 und Figur 4b den maximalen Abstand der beiden Träger 3, 7 darstellt.

Figuren 4a und 4b illustrieren Querschnittsansichten von exemplarischen Stapelanordnungen 1. Im vorliegenden Ausführungsbeispiel gemäß den Figuren 4a und 4b ist auf den Flächen der beiden Träger 3 und 7 auf jeweils der zugewandten Fläche eine Metallschicht 6 bzw. 10 vorgesehen. Ausnehmungen 9 sind an der Unterseite der oberen Metallschicht 10 zur Aufnahme eines etwaigen Lotüberschusses des Lotmittels 5 vorgesehen. Bei einem maximalen Abstand der beiden Träger 3 und 7, wie in Figur 4b dargestellt, ist eine Aufnahme eines überschüssigen Lotmittels 5 nicht notwendig, da das Lotmittel 5 für eine stabile Verbindung des Bauelementes 2 mit der oberen Metallschicht 10 keinen Überschuss bildet.

Wie in Figur 4a ersichtlich, kann es bei einer Verringerung des Abstandes zwischen den beiden Trägern 3 und 7 zu einem Überschuss an Lotmittel 5 kommen, welcher durch die Ausnehmungen 9 aufgenommen wird. Somit wird ein Ausfluss an der Seite der Metallschicht verhindert und eine etwaige Störung des Bauelementes 2 bzw. der kompletten Anordnung 1 verhindert.

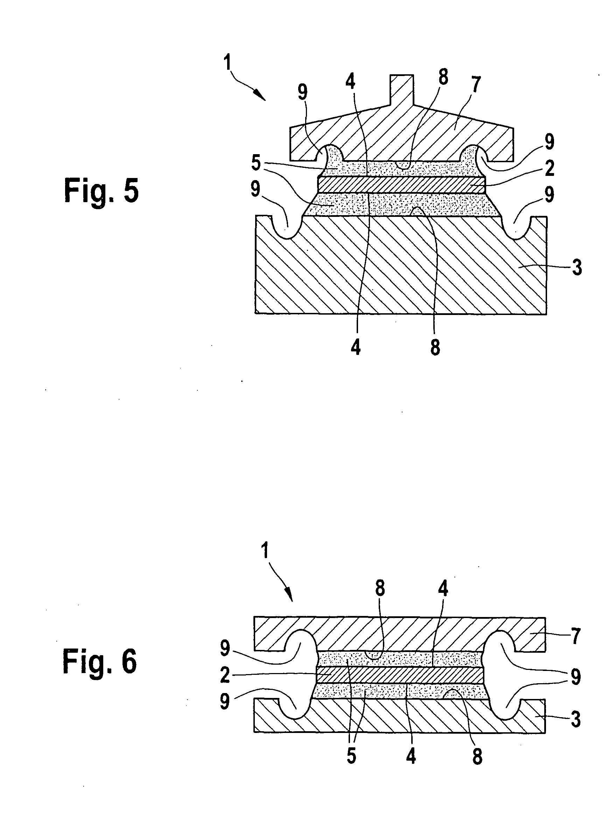

Figur 5 zeigt eine Querschnittsansicht einer Anordnung 1 gemäß einem weiteren Ausführungsbeispiel der vorliegenden Erfindung, wobei das Bauelement 2 als Einpressdiode 2 ausgebildet ist. Dieses Ausführungsbeispiel stellt eine mögliche Anordnung für einfache Dioden-Chips mit einer großflächigen Lotanbindung dar. Es soll verhindert werden, dass das Lotmittel 5 seitlich eine Brücke zwischen den beiden Substraten 3 und 7 bildet, indem sowohl in dem oberen Träger 7 bzw. in dem oberen Substrat 7 als auch in dem unteren Träger 3 bzw. Substrat 3 Ausnehmungen 9 für eine Aufnahme eines überschüssigen Lotmittels vorgesehen sind. Die Ausnehmungen 9 können oben und unten versetzt gegeneinander mit unterschiedlichen Außenerstreckungen positioniert werden, je nach Anordnung der entsprechenden Lotstellen 4 und der zugeordneten Lotgegenstellen 8. Beispielsweise ist im vorliegenden Beispiel das obere Substrat 7 ein Kopfdraht und das untere Substrat 3 ein Kupfer-Sockel.

Figur 6 zeigt eine Querschnittsansicht einer Anordnung 1 gemäß einem weiteren Ausführungsbeispiel der vorliegenden Erfindung. Gemäß diesem Ausführungsbeispiel sind ebenfalls sowohl im unteren Träger 3 als auch im oberen Träger 7 Ausnehmungen 9 vorgesehen. Im vorliegenden Ausführungsbeispiel handelt es sich beispielsweise um eine Anordnung 1, bei der die Ausnehmungen 9 zusätzlich zu der Funktion der Aufnahme eines überschüssigen Lotmittels 5 als Begrenzung des Lötvorgangs bzw. als räumliche Lötbegrenzung dienen. Dies ist beispielsweise bei Bauelementen 2 in Form von Kondensatoren, Induktivitäten oder Shunts vorteilhaft. Dabei erfolgt der Lötvorgang lediglich innerhalb des durch die Ausnehmungen 9 begrenzten Lötbereichs und eventuelle Tabubereiche werden vor einer nachteiligen Belötung bewahrt.

Somit wird durch die vorliegende Erfindung eine Anordnung geschaffen, durch welche eine Fertigungssicherheit und eine Kostenreduktion bei einem Lötvorgang erreicht wird. Bei entsprechender Formgebung und Positionierung der Ausnehmungen kann bei Bedarf mehr als 50 % des gesamten Lötdepots aufgenommen werden. Das Lötdepot kann hierdurch erhöht werden. Die Kontaktierungssicherheit steigt bei gleichzeitiger Reduktion der Gefahr von elektrischen Kurzschlüssen, hervorgerufen durch überschüssiges Lot. Die Fertigungssicherheit wird dadurch verbessert, wodurch die Ausbeute erhöht wird. Die zulässigen Toleranzen bei den Bauteilen können ebenfalls erhöht werden. Dies führt insgesamt zu einer nicht zu vernachlässigenden Kostenreduktion.

Bei einer entsprechenden Anordnung der Ausnehmungen entlang der äußeren Umfangslinie der Lötgegenstelle wird ein Auslaufen des Lotmittels auf dem Schaltungsträger, beispielsweise dem Substrat, verhindert. Neben der Funktion der Lotaufnahme können die Ausnehmungen zusätzlich oder vornehmlich die Funktion eines Lötstopps übernehmen, was üblicherweise zusätzliche Prozessschritte erfordern würde. Somit können auch hier die Kosten reduziert werden. Die Funktion des Lötstopps verhindert einerseits ein "Verschwimmen" bzw. Verrutschen der Bauelemente während des Lötprozesses und unterstützt gleichzeitig den Justagevorgang.

Die vorliegende Erfindung kann u.a. in der Hochstrom-Modul-Technologie eingesetzt werden, bei der beidseitig lötbare Power-MOS-Transistoren zwischen zwei DBC-Substrate (Direct-Bonded-Copper) gelötet werden.

Obwohl die vorliegende Erfindung vorstehend anhand bevorzugter Ausführungsbeispiel beschrieben wurde, ist sie darauf nicht beschränkt, sondern auf vielfältige Weise modifizierbar. Auch ist die Erfindung nicht auf die genannten Anwendungsmöglichkeiten beschränkt.

## Patentansprüche

1. Anordnung (1) zur Befestigung eines Bauelements (2), insbesondere eines elektronischen Leistungsbauelements (2), an mindestens einem Träger (3, 7), wobei ein Lotmittel (5) auf einer Lotstelle (4) auf der dem jeweiligen Träger (3, 7) zugewandten Oberfläche des Bauelements (2) vorgesehen ist,
**dadurch gekennzeichnet,**
**dass** mindestens eine Ausnehmung (9) in der der Lotstelle (4) zugewandten Oberfläche des jeweiligen Trägers (3, 7) für eine Aufnahme eines Lotmittelüberschusses vorgesehen ist.

2. Anordnung (1) nach Anspruch 1,
**dadurch gekennzeichnet, dass**
mehrere Ausnehmungen (9) symmetrisch zueinander in der der Lotstelle (4) zugewandten Oberfläche des jeweiligen Trägers (3, 7) angeordnet sind.

3. Anordnung (1) nach einem der Ansprüche 1 oder 2,
**dadurch gekennzeichnet, dass**
die Ausnehmung oder Ausnehmungen (9) im Bereich der äußeren Umfangslinie einer Lotgegenstelle (8) auf dem jeweiligen Träger (3, 7) angeordnet sind.

4. Anordnung (1) nach wenigstens einem der vorhergehenden Ansprüche,
**dadurch gekennzeichnet, dass**
die Ausnehmungen (9) eine halbschalenähnliche, wannenähnliche, dimpelähnliche, pyramidenähnliche oder kastenähnliche Form aufweisen.

5. Anordnung (1) nach wenigstens einem der vorhergehenden Ansprüche,
**dadurch gekennzeichnet, dass**
die Tiefe der Ausnehmungen (9) maximal drei Viertel der Dicke des jeweiligen Trägers (3, 7) entspricht.

6. Anordnung (1) nach wenigstens einem der vorhergehenden Ansprüche,
**dadurch gekennzeichnet, dass**
die Ausnehmungen (9) jeweils als halbschalenförmige Löcher mit einer Breite von ca. 0,6 mm und einer Tiefe von ca. 0,2 mm bis 0,25 mm ausgebildet sind.

7. Anordnung (1) nach wenigstens einem der vorhergehenden Ansprüche,
**dadurch gekennzeichnet, dass**
in etwa bis zu 50 - 70 % des gesamten auf der Lotstelle (4) aufgebrachten Lotmittels (5) in den Ausnehmungen (9) aufnehmbar ist.

8. Anordnung (1) nach wenigstens einem der vorhergehenden Ansprüche,
**dadurch gekennzeichnet, dass**
die Ausnehmungen (9) in der Verdrahtungsebene eines Schaltungsträgers, beispielsweise eines Leistungssubstrates, vorgesehen sind.

9. Anordnung (1) nach wenigstens einem der vorhergehenden Ansprüche,
**dadurch gekennzeichnet, dass**
die Ausnehmungen (9) als Lotbegrenzungen dienen.

10. Anordnung (1) nach wenigstens einem der vorhergehenden Ansprüche,
**dadurch gekennzeichnet, dass**
die Ausnehmungen (9) jeweils mittels eines nasschemischen Ätzverfahrens, Sputtern, eines physikalisch-chemischen Ätzverfahrens, eines formgebundenen Fertigungsverfahrens, Fräsen oder mittels eines ähnlichen Verfahrens gebildet sind.
